# EUROPÄISCHE PATENTSCHRIFT

(11) **EP 2 236 287 B1**
(45) Veröffentlichungstag und Bekanntmachung des Hinweises auf die Patenterteilung: **05.03.2014**
(21) Anmeldenummer: 09177765.6
(22) Anmeldetag: 02.12.2009
(51) Int. Cl.: B32B 37/10, B32B 38/00, B30B 5/02, B30B 5/04, B30B 15/34, H01L 31/18

(54) **Laminationsvorrichtung**
Lamination device
Dispositif de laminage

(30) Priorität: 31.03.2009 DE 102009002023
(43) Veröffentlichungstag der Anmeldung: 06.10.2010
(73) Patentinhaber: SM InnoTech GmbH & Co. KG, 46395 Bocholt (DE)
(72) Erfinder: Stevens, Hans Gerd, 46399 Bocholt (DE)
(74) Vertreter: HOFFMANN EITLE

(56) Entgegenhaltungen:
- WO-A2-2006/128699
- DE-A1- 3 129 206
- DE-A1- 4 026 802
- DE-A1- 4 222 262
- DE-A1-102004 033 540
- DE-U1-202008 008 799
- US-A- 4 350 545
- US-A- 5 593 532
- US-B1- 6 367 530

## Beschreibung

Die vorliegende Erfindung betrifft eine Laminationsvorrichtung für Bauteilestapel, insbesondere eine Vorrichtung zum Laminieren von Photovoltaik-Modulen. Weiter betrifft die Erfindung ein entsprechendes Verfahren zum Laminieren von Bauteilestapeln.

### Stand der Technik

Laminationsvorrichtungen der eingangs genannten Art, auch Membranpressen genannt, werden eingesetzt, um aus vorzugsweise plattenförmigen Bauteilen bestehende Bauteilestapel durch Druck unter Wärmeeinwirkung und/oder unter Vakuum miteinander zu verpressen. Beispiele von Komponenten sind insbesondere Photovoltaik-Module, aber auch andere Verbundbauteile wie Verbundglasscheiben und Composite-Bauteile.

Solche Laminationsvorrichtungen umfassen im Allgemeinen eine oder mehrere Presskammern, in die die Bauteilestapel mithilfe eines im unteren Teil der Kammer durchlaufenden Transportbands eingebracht werden. Dabei handelt es sich gewöhnlich um ein Foerderband, auf dem die Bauteilestapel durch oder in bzw. aus die Presskammern transportiert werden. In der Presskammer ist oberhalb der Bauteile ein Releasesheet vorgesehen, welches Laminationsreste, wie zum Beispiel Folienreste, die während des Verpressens aus dem Bauteilestapel heraus gedrückt werden, vom Bauteilestapel aufnimmt und so die eingesetzte Anpressmembran vor Verunreinigung schützt. Zum Abtransport der Laminationsreste ist dieses Releasesheet als durch den oberen Teil der Presskammer durchlaufendes Umlaufband ausgestaltet, wobei außerhalb der Presskammer Reinigungseinrichtungen, auch für das Transportband, vorgesehen sind, die die Laminationsreste vom Releasesheet und/oder dem Transportband entfernen. Die Kammer umfasst mindestens eine Heizeinrichtung, beispielsweise eine elektrische Heizplatte oder eine Wärmetauscheinrichtung, sowie eine flexible und elastische, beispielsweise aus Silikon bestehende Anpressmembran, die oberhalb der eingebrachten Bauteilestapel angeordnet ist. Die Anpressmembran ist druckdicht, beispielsweise außerhalb der Kammern mithilfe von Spannvorrichtungen eingespannt, wodurch ein oberer druckdichter Kammerteil gebildet wird. Der untere Kammerteil, in den die Bauteilestapel auf den Transportbändern eingefahren werden, kann druckdicht verschlossen werden. Die obere und untere Kammer können jeweils mit unter Druck stehendem Gas (z.B. Luft) beaufschlagt oder einfach nur belüftet werden bzw. evakuiert werden. Die Heizplatte, die unterhalb der Bauteilestapel im unteren Kammerteil vorgesehen wird, dient dazu, den Bauteilestapeln in der Kammer die zum Laminieren (Z.B. für das Aufschmelzen der eingesetzten Folien) erforderliche Wärme zuzuführen. Ferner ist ein Stifthubsystem zum Anheben der Bauteilestapel vorgesehen, dessen Mechanik unterhalb der Heizplatte angeordnet ist und dessen Stifte durch Öffnungen in der Heizplatte hindurchgreifen.

Wie oben erwähnt, werden im Betrieb die Bauteilestapel auf dem Förderband in die Presskammer eingefahren und kommen auf der Heizplatte zu liegen, die aufgrund ihrer thermischen Trägheit und der gewünschten Taktzeit bereits auf Solltemperatur erhitzt ist. Der obere Kammerteil ist bereits evakuiert, wodurch die Anpressmembran an der oberen Kammerwand anliegt. Die Kammer wird dann druckdicht verschlossen, der untere Kammerteil evakuiert und die Bauteilestapel werden im Vakuum oder bereits kurz nach den Einfördern vom Stifthubsystem angehoben, um den Wärmeeintrag zu reduzieren. Die Evakuierung dient der Ausgasung der Bauteilestapel vor und während dem Aufschmelzungs- und/oder Vernetzungsschritt. Dabei werden die Bauteilestapel später auf die zum Laminieren notwendige Vernetzungstemperatur (beispielsweise ca. 150°C) erhitzt. Nach einer gewissen Vakuumphase (etwa 4 Minuten) werden die Bauteilestapel wieder auf die Heizplatte zurückgefahren, um die eigentliche und gewollte Erwärmung der Bauteilestapel zu erwirken. Ist die entsprechende Solltemperatur erreicht, wird der obere Kammerteil belüftet, wodurch die Anpressmembran von oben auf die Bauteilestapel gepresst wird. Durch den Anpressdruck und den weiteren Wärmeeintrag werden die Schichten der Bauteilestapel miteinander verpresst und verbunden. Nach einer gewissen Verpressungszeit wird die untere Kammer wieder belüftet und die obere wieder evakuiert, so dass sich die Anpressmembran wieder an der oberen Kammerwand befindet. Nach dem Öffnen der Kammer kann der verpresste Stapel abgekühlt werden, was auf einer Heiz-/Kühlplatte in der Kammer oder mit einer separaten Abkühlstation bzw. Kühlpresse erfolgen kann. Die Heiz-/Kühlplatte ist dabei Teil einer Heiz-/Kühlvorrichtung, die beispielsweise auf Wärmetausch mittels eines Heiz- bzw. Kühlmediums wie Öl basiert.

Die beschriebene Anlage kann aufgrund der kontinuierlichen Beschickung schnell getaktet werden. Nachteilig ist allerdings, dass aufgrund der Stifthubmechanik unterhalb der Heizplatte sehr viel Bauraum benötigt wird. Auch müssen die Kammerwände aufgrund des hohen benötigten Unterdrucks bzw. Vakuums (in der Größenordnung von 1 mbar) eine ausreichende Dicke oder Versteifung aufweisen, was sie und die Anlage insgesamt entsprechend schwer und teuer macht. Selbstverständlich tragen auch die Heizplatte sowie die Stifthubeinrichtung nicht unwesentlich zum Gewicht und Preis der Anlage bei. Die in der Heizplatte vorgesehenen Öffnungen für den Stifthub werden zudem häufig durch Laminationsreste und Vernetzungsabgase verunreinigt, was zum Steckenbleiben oder Verkleben und somit zum Ausfall einiger Stifthubelemente führt. Die Stifthubelemente sind zudem aufgrund ihrer hohen Zahl (ca. 200) kaum überwachbar. Der Stifthub verspannt zudem beim Heben der Bauteilestapel das Förderband und das Releasesheet zu einer Vakuumtasche, dessen Evakuierung erschwert ist und lange Evakuierungszeiten erfordert. Die durch mechanische sowie die durch die Wärmezyklen bedingte thermische Belastung tragen ebenfalls in hohem Grad zur Alterung und Abnutzung des Foerderbands und insbesondere des aus Glasfasergewebeband bestehenden Releasesheets bei. Einer der wichtigsten Nachteile herkömmlicher Laminationsanlagen ist denn auch die Frequenz des Releasesheetwechsels und der dazu nötige Aufwand.

Ein weiteres Verschleißelement sind die Anschlüsse der Heizvorrichtung und die elektrischen Bauteile, wie Temperatursensoren, die durch die in der Presskammer freigesetzten Vernetzungsabgase chemisch angegriffen werden.

Jedoch ist der eben beschriebene Prozess auch für das Laminierergebnis nicht optimal. Einerseits bilden sich durch das Verspannen von Releasesheet und Transportband, bedingt durch das Anheben der Module durch den Stifthub, so genannte Vakuumtaschen aus, die ein Evakuieren erschweren. Durch die Erhitzung der Bauteilestapel von unten ist der Wärmeeintrag in den unteren Schichten des Stapels höher als auf der oberen Seite, was zu einem Schüssel-artigen Verziehen, der so genannten "Schüsselung" (in Englisch "bending") der Stapel, führt und das Laminationsergebnis hinsichtlich der Homogenität nachteilig beeinflusst. Die Bauteilestapel sind dabei beim Verpressen nicht mehr eben und haben unterschiedliche Temperaturen in den Randbereichen und in der Mitte. Dadurch kann keine gleichmäßige Vernetzung stattfinden, so dass eine verlängerte Prozesszeit gewählt werden muss. Da die Bauteilestapel außerdem als untere Schicht häufig eine Glasplatte aufweisen (wie zum Beispiel bei Solarzellenmodulen), die nur schlecht Wärme überträgt, ist der Heizvorgang auch Energie intensiver. Ebenfalls nachteilig für den Energieverbrauch ist, dass bei Vorsehen der Kühlvorrichtung zusammen mit der Heizvorrichtung beim Abkühlen Energie vernichtet wird.

Die Druckschrift WO 2006/128699 A1 offenbart eine Maschine zur Herstellung von plattenförmigen Elementen aus Verbundmaterial die dem Oberbegriff des Asnpruchs 1 entspricht. Jedoch ist die Membrane als Pressmembrane von oben angeordnet. Die zu laminierenden Elemente befinden sich nicht auf der Membrane, sondern darunter, und werden von der Membrane gegen die unten liegende Heizplatte gepresst.

Auch sind die oben beschriebenen bisherigen Anlagen und die damit durchgeführten Laminationsverfahren ungeeignet, Bauteilestapel zu laminieren, in welchen schlecht wärmeleitende Werkstoffe als Substrat verwendet werden, da eine Erwärmung auf die Vernetzungstemperatur von unten durch das schlecht wärmeleitende Substrat erfolgen muss und somit sehr viel Zeit in Anspruch nehmen würde. Dieses ungünstige Wärmeintragsverhalten wird durch das Anheben mittels des Stifthubsystems noch zusätzlich verschlechtert. Zu den schlecht wärmeleitenden Materialien zählen dabei insbesondere auch poröse Materialien, bei denen die Entgasung aufgrund der Porosität erschwert ist und somit einer besonders gründlichen vollständigen Evakuation, teilweise auch ohne vorzeitige oder mit bedingter Erwärmung, bedarf, welche jedoch bei herkömmlichen Anlagen aufgrund der oben erwähnten Ausbildung von Vakuumtaschen nicht zuverlässig garantiert werden kann. Des Weiteren können mit herkömmlichen Stifthubvorrichtungen des Stands der Technik nur Bauteilestapel, und somit Substrate, bis zu einem bestimmten Gewicht angehoben werden. Insgesamt ist also die Anwendbarkeit solcher herkömmlicher Laminatoren und Laminationsverfahren auf Bauteilestapel beschränkt, die leichte, dünne bzw. gut wärmeleitende Substrate enthalten.

### Darstellung der Erfindung

Es ist somit eine Aufgabe der vorliegenden Erfindung, eine Laminationsvorrichtung der eingangs genannten Art zu entwickeln, die die oben genannten Nachteile überwindet und eine einfachere und produktivere Herstellung von Laminaten erlaubt. Diese Aufgabe wird durch eine Laminationsvorrichtung nach Anspruch 1, ein Laminationsverfahren nach Anspruch 12 gelöst. Vorteilhafte Weiterbildungen der Erfindung sind in den jeweiligen Unteransprüchen definiert.

Eine erfindungsgemäße Laminationsvorrichtung zum Laminieren von Stapeln von Bauteilen umfasst mindestens eine luftdicht verschließbare, eine obere und eine untere Kammerwand umfassende und mit mindestens einer Heizvorrichtung ausgestattete Presskammer zur Aufnahme eines oder mehrerer Bauteilestapel sowie ein oberhalb der Bauteilestapel vorgesehenes Releasesheet. Die Laminationsvorrichtung umfasst weiter eine flexible Anpressmembran, auf der der mindestens eine Bauteilestapel von der unteren Kammerwand abhebbar aufgenommen wird. Unter der Anpressmembran ist ein unterer Kammerteil ausgebildet und über ihr ist ein oberer Kammerteil ausgebildet, die jeweils belüftbar und evakuierbar sind. "Belüftbar" bzw. "belüften" bedeutet in dieser Anmeldung sowohl, dass Luft oder Gas beispielsweise mit Atmosphärendruck in den bzw. die Kammerteile eingelassen wird, als auch dass diese Luft oder dieses Gas mit Überdruck zugeführt werden. Der obere Kammerteil wird somit von der Membran und der oberen Kammerwand begrenzt, während der untere Kammerteil von der Membran und der unteren Kammerwand begrenzt wird. Anstatt von Luft oder Gas zur Belüftung können aber auch Fluide wie Öl verwendet werden.

Im Betrieb werden Bauteilestapel in die Kammer beschickt, die Kammer wird verschlossen und evakuiert. Ist die Heizplatte in der unteren Kammerwand vorgesehen, kann nun ein zu schnelles Erwärmen der Bauteilestapel dadurch verhindert werden, dass im oberen Kammerteil im Verhältnis zum unteren Kammerteil ein Unterdruck erzeugt wird, der dazu führt, dass sich die Anpressmembran nach oben wölbt und die Bauteilestapel anstelle des Stifthubs von der unteren Kammerwand abhebt. Alternativ kann auch mittels Überdruck in der unteren Kammer ein Anheben der Bauteilestapel erwirkt werden. Eine Verpressung kann dann wie im Stand der Technik erfolgen. Ist jedoch, wie bevorzugt, die Heizvorrichtung in der oberen Kammerwand vorgesehen, erfolgt die Verpressung dadurch, dass die Bauteilestapel von den Anpressmembranen gegen die obere Kammerwand mit der Heizvorrichtung gedrückt werden. Dies geschieht durch Evakuierung des oberen Kammerteils, wodurch das Releasesheet an der oberen Kammerwand anliegt und mit ihr in gutem thermischen Kontakt steht, und durch gleichzeitige Belüftung des unteren Kammerteils, wodurch die Anpressmembran ebenfalls nach oben gedrückt wird und somit den zwischen Releasesheet und Anpressmembran liegenden Bauteilestapel gegen das an der oberen Kammerwand anliegende Releasesheet presst. Durch gezielte Wärmeinwirkung von der in der oberen Kammerwand angeordneten Heizvorrichtung kann nun eine wirkungsvolle Verpressung erfolgen. Das Releasesheet ist bevorzugt elastisch, damit es empfindliche oder zerbrechliche Bauteile wie die Halbleiterschichten von Photovoltaik-Modulen an der Oberseite des Bauteilestapels einbettet und dadurch beim Anpressen an die obere Kammerwand vor Beschädigung, beispielsweise durch punktuelle Belastung der Halbleiterschichten, schützt.

Ein Vorteil der erfindungsgemäßen Laminationsvorrichtung ist, dass auf die im Stand der Technik nötigen Stifthubeinrichtungen verzichtet werden kann und somit die Bauhöhe der Laminationsvorrichtung beträchtlich niedriger ausfallen kann, da kein Raum unter einer Heizplatte vorgesehen werden muss. Ist die Heizplatte in der oberen Kammerwand vorgesehen, ist es nun auch nicht mehr nötig, die Bauteilestapel während der Evakuierung erst von einer untenliegenden heißen Heizplatte wegzuheben und dann wieder nach unten gegen die Heizplatten zu pressen, was zu kürzeren Produktionszeiten und somit einer Steigerung der Effizienz der Anlage führt.

Die untere Kammerwand kann als Auflage benutzt werden, und eine Vorwärm- und/oder Kühlvorrichtung können nun in der unteren Kammerwand eingebaut werden. Das bedeutet auch, dass die Bauteilestapel nun nicht bereits beim Einfahren stark erhitzt werden, sondern auf eine "kalte" bzw. vorgewärmte Auflage eingefahren werden. Erst beim anschließenden Andrücken an die obere Kammerwand ist der Wärmeeintrag durch die dort angeordnete, integrierte Heizvorrichtung vorgesehen. Sämtliche Anschlüsse können sich somit korrosionsgeschützt an der Außenseite der oberen Kammerwand außerhalb der Presskammer befinden.

Außerdem kann den erfindungsgemäß möglichen Verzicht auf die separate Heizplatte die Innenhöhe und somit das Volumen der Presskammer deutlich verringert werden, was den Vorteil hat, dass kleinere Vakuumpumpen verwendet werden können. Dies führt denn auch zu kürzeren Auspumpzeiten und somit insgesamt geringeren Prozesszeiten. Ein weiterer nicht unbeachtlicher Vorteil hiervon ist, dass aufgrund der kompakteren Bauweise und des geringeren zu evakuierenden Raums die Kammerwände dünner gemacht werden können, und somit das Gewicht der Anlage verringert wird. Außerdem können weniger feste Stähle für die Kammerwände eingesetzt werden, was die Kosten der Anlage senkt.

In Bezug auf die Qualität der Laminaten bietet die erfindungsgemäße Laminationsvorrichtung ebenfalls Vorteile. Die Anpressmembran wirkt nämlich aufgrund der Beaufschlagung mit einem Druckgefälle homogen auf die Oberfläche des Bauteilestapels ein, es werden also alle in der Presskammer befindliche Bauteilestapel gleichmäßig und ohne so genanntes "Shifting" verpresst.

Da die Bauteilestapel erst beim Andrücken bzw. Verpressen an der oberen mit einer Heizvorrichtung versehenen Kammerwand einen Wärmeintrag erhalten, bleiben die Bauteilestapel eben und können effektiver und über die Fläche des Bauteilestapels gleichmäßiger vernetzt werden. Ferner können sich keine Vakuumtaschen ausbilden, da zwischen dem Bauteilestapel und der oberen Wand nur das Releasesheet vorgesehen ist. Dies führt zu einer über die gesamte Presskammerfläche gleichmäßigeren Vernetzung der Bauteilestapel und besseren Evakuierung. Weiterhin ist auch die Wärmeübertragung von der Heizvorrichtung auf die Bauteilestapel schneller, da letztere als obere Schicht zumeist dünne Folien, beispielsweise aus TPT, EVA oder TPU, aufweisen, die praktisch kaum isolieren. Dies beschleunigt den Heizvorgang wesentlich und führt zu kürzeren Prozesszeiten.

In einer bevorzugten Ausführungsform ist die Anpressmembran als durch die Presskammer laufendes Endlosband ausgebildet und ist geeignet, die Bauteilestapel in die Presskammer zu fördern. Die Anpressmembran kann somit sowohl die Beschickung der Presskammer als das Andrücken der Bauteilestapel während des Laminationsvorgangs durchführen. Damit wird zunächst natürlich ein Förderband eingespart. Auch ist es dadurch möglich, die Anpressmembran außerhalb der Pressvorrichtung zu reinigen, ohne die Anlage anhalten zu müssen.

Zusätzlich oder alternativ kann das Releasesheet vorteilhafterweise als durch die Presskammer laufendes Endlosband ausgebildet sein. Dies erleichtert die Reinigung des Laminationsrückstände aufnehmenden Releasesheets.

Die Anpressmembran und das Releasesheet sind bevorzugt jeweils einzeln vorspannbar. Sie können einerseits direkt an den Außenwänden der Presskammer aufgehängt und eingespannt sein und durch eine eigene Spannvorrichtung, beispielsweise durch Verschraubung, vorgespannt werden. Andererseits können sie im Fall der Ausgestaltung als Endlosbänder auch durch die dazu vorgesehenen Förderrollen oder auf einem Kettentrieb vorgespannt werden, wobei die separate Vorspannvorrichtung entfällt. Gleichzeitig können die Membranen aber auch bei Bedarf mit den hier genannten Mitteln nachgespannt werden. Dies bewirkt eine Verlängerung der Einsatzlebensdauer von Anpressmembranen, die bisher aufgrund Erschlaffens hätten ausgetauscht werden müssen.

In einer besonders vorteilhaften Ausgestaltung ist hierbei in oder an der unteren Kammerwand eine Kühlvorrichtung und/oder eine Vorwärmvorrichtung angeordnet. Nachdem der Bauteilestapel an der oberen Kammerwand verpresst wurde, kann der obere Presskammerteil belüftet und der untere Presskammerteil evakuiert werden, sodass der Bauteilestapel gegen die Kühlplatte gepresst und abgekühlt wird. Es ist somit nicht mehr notwendig, eine separate Kühlpresse der Laminationsvorrichtung nachzuschalten. Dies eliminiert somit auch die für den Transport zur Kühlpresse bisher notwendige Transportzeit und das Risiko von damit verbundenen Transportschäden und Delaminierungen. Insgesamt ergeben sich wieder kürzere Prozesszeiten mit dem damit zusammenhängenden Kostenvorteil. Die Vorwärmplatte hingegen kann dazu genutzt werden, beim Einfahren die Bauteilestapel auf eine Temperatur unterhalb der Vernetzungstemperatur vorzuwärmen (z.B. auf ca. 90°C), was ein unkontrolliertes Aufwärmen mit Bildung so genannter "hot spots" verhindert.

In einer weiteren Ausführungsform ist das Releasesheet gasdicht ausgebildet und definiert mit der Anpressmembran einen mittleren Kammerteil. Alternativ ist über dem Releasesheet eine obere Membran angeordnet, die mit der Anpressmembran einen mittleren Kammerteil definiert. Durch das gasdichte Releasesheet oder die obere Membran kann durch Erzeugung geeigneter Druckverhältnisse zwischen dem oberen und unteren Kammerteil die Höhe, auf die die Anpressmembran die Bauteilestapel in der Presskammer hebt und hält, genau eingestellt werden, was beispielsweise eine genau kontrollierte Erwärmung vor dem Verpressen ermöglicht. Der mittlere Kammerteil wird dabei bevorzugt evakuiert und presst so die Bauteilestapel zusammen. Ein unbeabsichtigtes Verrutschen wird so verhindert. Auch ist es andererseits möglich, den oberen Kammerteil zu belüften und den unteren zu evakuieren, um so den Bauteilestapel nach dem Verpressen beispielsweise gegen eine Kühlvorrichtung (Kühlplatte) zu pressen. Ist eine Vorwärmvorrichtung (-platte) in der unteren Kammerwand vorgesehen, so können die nach dem Verpressen noch im Wesentlichen auf Vernetzungstemperatur befindlichen Bauteilestapel gegen die kühlere Vorwärmvorrichtung gepresst werden und so gekühlt werden, wobei die abgegebene Wärme zudem für nachfolgende Vorwärmvorgänge wieder verwendet werden kann.

In einer besonders bevorzugten Ausführungsform ist zwischen der oberen und unteren Kammerwand ein die Kammer randseitig umlaufender Dichtrahmen vorgesehen, wobei innerhalb des Dichtrahmens mindestens ein im Wesentlichen parallel zu den Kammerwänden verlaufendes Abstandselement vorgesehen ist, das den von Dichtrahmen, Releasesheet und Anpressmembran gebildeten Raum teilweise oder vollständig in Unterbereiche unterteilt. Die Abstandselemente sind dabei im einfachsten Fall längliche Elemente wie zum Beispiel Streben, die den umlaufenden Dichtrahmen nicht zwingend berühren müssen. Es sind somit lediglich eingelegte, mit dem umlaufenden Dichtrahmen nicht verbundene Abstandselemente denkbar. Eine mögliche Ausgestaltung des Abstandselements ist kreuzförmig. Ebenfalls wären Seile als Abstandelemente vorstellbar, die durch die Kammer gespannt werden. Die Abstandelemente besitzen dabei bevorzugt eine Dicke, die im Wesentlichen dem Abstand der Kammerwände voneinander im geschlossenen, aber nicht evakuierten Zustand entspricht. Diese Dicke kann auch im Wesentlichen der Dicke des Dichtrahmens entsprechen. Der Dichtrahmen, der schnell wechselbar eingespannt sein kann, dient der druckdichten Abdichtung der Presskammer nach außen hin, während das mindestens eine ihn ganz oder teilweise unterteilende Abstandselement den die Bauteilestapel aufnehmenden Bereich der Presskammer entsprechend in Unterbereiche unterteilt. Durch den Dichtrahmen zusammen mit dem/den Abstandselement/-en wird der Laminationsvorrichtung eine zusätzliche Versteifung ermöglicht, da die obere und untere Presskammerwand im geschlossenen Zustand nun nicht mehr nur über den umlaufenden Rand des Dichtrahmens aneinander anliegen, sondern sich auch dem/den Abstandselement/-en entlang aneinander abstützen. Aufgrund der gleichmäßigeren Lastverteilung können die Kammerwände nun in Leichtbauweise ausgeführt werden, was wiederum eine Gewichtseinsparung erlaubt. Da sich die Anpressmembran beim Evakuieren des oberen und belüften des unteren Kammerteils auch nicht mehr ballonförmig von der Mitte der Presskammer aus nach oben wölbt, was zu unterschiedlichem Erhitzen/Aufschmelzen und Verpressen der auf der Anpressmembran liegenden Bauteilestapel am Rand der Kammer im Vergleich zu deren Mitte führen würde, wird ein über die Presskammerfläche gleichmäßigeres und/oder gleiches Verpressen aller in der Laminationsvorrichtung eingebrachten Bauteilestapel erzielt.

Bevorzugt ist das mindestens eine Abstandselement mit dem Dichtrahmen einstückig ausgebildet. Durch die einstückige Ausbildung wird eine besonders gute Stabilität der Anordnung aus Dichtrahmen und mindestens einem Abstandselement erzielt.

Bevorzugt unterteilt das mindestens eine längliche Abstandselement den Dichtrahmen in gleich große Unterbereiche. Dadurch werden für den Laminationsvorgang genau vorbestimmbare Unterteilungen der Presskammer bzw. des die Bauteilestapel aufnehmenden Raums erzeugt, die bei der Beschickung, insbesondere mit den erfindungsgemäßen Membranförderbändern berücksichtigt werden können. So können die Bauteilestapel genau an die Stelle in der Presskammer eingeführt werden, an der sich ein einer Unterteilung entsprechender den Bauteilestapel aufnehmender Unterbereich befindet.

Besonders bevorzugt sind im Dichtrahmen und/oder dem/den Abstandselement/-en mindestens eine durchgehende Belüftungsöffnung vorgesehen, durch welche die Unterteilungen und somit der im geschlossenen Zustand unterteilte, die Bauteilestapel aufnehmende Unterbereich belüftet, evakuiert oder mit Druck beaufschlagt werden können. Die Öffnung(en) tragen so zu einem gleichmäßigen Druckauf- und -abbau bei, der sich wiederum in einem gleichmäßigeren Laminierungsergebnis über die gesamte Fläche der Laminierungsvorrichtung widerspiegelt.

Gemäß einem weiteren Aspekt betrifft die Erfindung auch ein Verfahren zum Laminieren von Stapeln von Bauteilen, das die folgenden Schritte umfasst: Zunächst werden ein oder mehrere Bauteilestapel in eine Presskammer mit einer oberen und einer unteren Kammerwand eingefahren oder eingelegt, in der eine Anpressmembran und über ihr ein Releasesheet angeordnet sind, die den mindestens einen Bauteilestapel von der unteren Kammerwand abhebbar zwischen sich aufnehmen. Dann wird die Presskammer druckdicht verschlossen, und der über dem Releasesheet liegende Presskammerteil sowie der den mindestens einen Bauteilestapel aufnehmende, zwischen Releasesheet und Presskammer liegende Bauteilaufnahme wird evakuiert. Im nächsten Schritt wird der unter der ersten Anpressmembran liegende Kammerteil belüftet oder mit Druck beaufschlagt, wodurch der mindestens eine Bauteilestapel von der unteren Kammerwand (12) abgehoben, an die obere Kammerwand gedrückt und durch Hitzeinwirkung von oben verpresst wird.

Durch das erfindungsgemäße Verfahren kann, wie schon bei der Vorrichtung, auf die im Stand der Technik nötigen Stabhubeinrichtungen vollends verzichtet werden. Auch werden die gleichen Vorteile in Bezug auf Bauhöhe, Volumen, Auflage und Heiz- oder Kühlvorrichtungen sowie Prozesszeiten und Gleichmäßigkeit des Laminationsergebnisses erzielt. Dadurch erlaubt das erfindungsgemäße Verfahren insbesondere eine wirtschaftliche Fertigung durch Verkürzung der Taktzeiten, Verringerung des Energieverbrauchs und Vermeidung von Ausschuss durch verbesserte Prozessführung.

Dabei kann der mindestens eine Bauteilestapel auf separaten Förderbändern in die Presskammer eingeführt werden. Bevorzugt ist aber, dass die Anpressmembran und/oder das Releasesheet jeweils als Endlosband ausgestaltet sind und durch die Presskammer laufen, und die Anpressmembran geeignet ist, den Bauteilestapel in die Presskammer zu fördern. Die Anpressmembran führt somit sowohl die Beschickung der Presskammer als auch das Andrücken der Bauteilestapel während des Laminationsvorgangs durch. Auf separate Förderbänder kann verzichtet werden. Weiterhin wird die Wärmeübertragung von der in der Presskammer vorgesehen Heizvorrichtung auf die zu verpressenden Bauteile wesentlich verbessert.

Bevorzugt wird der mindestens eine Bauteilestapel nach Einführen in die Presskammer zunächst auf eine Aufwärmtemperatur erwärmt, vorzugsweise mit Hilfe einer Vorwärmplatte in der unteren Kammerwand, und dann während des Schritts des Andrückens an die obere Kammerwand auf eine Vernetzungstemperatur erhitzt, wobei die Vernetzungstemperatur höher als die Aufwärmtemperatur ist. Dadurch wird ein unkontrolliertes Aufwärmen über die vorgegebene Aufwärmtemperatur hinaus vermieden, das ansonsten zu so genannten "hot spots" im Bauteilestapel führen würde. Dies erhöht die Verfahrenssicherheit und verringert den Ausschuss. Gleichzeitig wird der Bauteilestapel dennoch vorgewärmt, was beim nachfolgenden Anpressen mithilfe der Anpressmembran an eine auf Vernetzungstemperatur befindliche Heizplatte eine kürzere Behandlungs- und somit Prozesszeit sowie eine Energieeinsparung bewirkt.

Es ist besonders bevorzugt, dass der Schritt des Belüftens oder mit Druck Beaufschlagens einen ersten Teilschritt umfasst, bei dem die Anpressmembran den mindestens einen Bauteilestapel auf eine von der oberen und der unteren Kammerwand beabstandete Position anhebt und dort hält, und einen darauf folgenden zweiten Teilschritt umfasst, bei dem der mindestens eine Bauteilestapel an die obere Kammerwand gedrückt und durch Hitzeeinwirkung von oben verpresst wird. Mit anderen Worten kann die Anpressmembran den Bauteilestapel beispielsweise auf "halbe Höhe" anheben, wodurch der Stapel langsamer erhitzt oder abgekühlt wird als durch sofortiges direktes Andrücken gegen die mit Heizvorrichtung versehen obere Kammerwand bzw. untere Kühlplatte. Die Höhe kann dabei durch Weg-Zeit-Messungen, beispielsweise mit Ultraschallmessgeräten oder Stiftmessern gemessen und durch entsprechende Druckeinstellung im unteren Kammerteil geregelt werden.

In einer vorteilhaften Ausführungsform ist das Releasesheet gasdicht ausgebildet oder ist über dem Releasesheet eine obere Membran vorgesehen, um mit der Anpressmembran einen mittleren Kammerteil zu definieren, und nach dem Schritt des Verpressens wird der mindestens eine Bauteilestapel durch Belüften oder mit Druck Beaufschlagen des oberen und/oder mittleren Kammerteils und Evakuieren des unteren Kammerteils mithilfe des gasdichten Releasesheets oder der oberen Membran gegen die untere, eine Kühlvorrichtung und/oder eine Vorwärmvorrichtung umfassende Presskammerwand gedrückt und so abgekühlt.

Dieser Schritt wird also in der selben Laminationsvorrichtung durchgeführt, ein Zeit in Anspruch nehmender Transport der Bauteilestapel vom Verpressen im Laminator zu einer separaten Kühlpresse ist nicht mehr notwendig. Somit wird wieder Prozesszeit eingespart und des Weiteren werden auch mögliche Beschädigungen am Bauteilestapel während des Transports vermieden. Ist eine Vorwärmvorrichtung (-platte) in der unteren Kammerwand vorgesehen, so können die nach dem Verpressen noch im Wesentlichen auf Vernetzungstemperatur befindlichen Bauteilestapel gegen die kühlere Vorwärmvorrichtung gepresst werden und so gekühlt werden, wobei die abgegebene Wärme zudem für nachfolgende Vorwärmvorgänge wieder verwendet werden kann.

Mit der erfindungsgemäßen Vorrichtung bzw. mit dem erfindungsgemäßen Verfahren kann aus einem Bauteilestapel ein laminiertes Produkt hergestellt werden, das ein Substrat und eine bevorzugt transparente Deckschicht umfasst, die mithilfe einer oder mehrerer zwischen sie gelegten schmelzbaren Laminationsfolie miteinander verpresst sind, wobei das Substrat vorzugsweise eine geringe Wärmeleitfähigkeit besitzt, die kleiner als ungefähr 3,5 W/(m·K), bevorzugt kleiner als 2,9 W/(m·K), besonders bevorzugt kleiner als 2,3 W/(m·K) ist.

In anderen Worten umfasst der Bauteilestapel das Substrat, eine oder mehrere zwischengelegte schmelzbare Laminationsfolien und die bevorzugt transparente Deckschicht.

Das Substrat kann dabei poröses Material als Material mit geringer Wärmeleitfähigkeit (<3,5 W/(m·K)) umfassen, zum Beispiel Steinmaterial. Der Begriff "Steinmaterial" umfasst dabei sowohl Naturstein wie Granit, Marmor, Sandstein oder Kalkstein, als auch künstlich hergestellte Steinarten wie Beton, Estrich, Ziegel, Fließen und ähnliches, aber auch vorgefertigte, aus verfugten Fließen zusammengesetzte Stein- oder Fließenpaneele. Besondere Vorteile ergeben sich beim Einsatz der erfindungsgemäßen Vorrichtung bzw. des Verfahren mit diesen Materialien daraus, dass kein separater Vorbehandlungsschritt mehr notwendig ist, um die Oberflächen des Substrats aufgrund Porosität zu versiegeln, wie zum Beispiel durch Schleifen, Einlassen mit Kunstharzen oder Kristallisierung mit CaF₂. Das poröse Material wird zuverlässig entgast und kann aufgrund des Wärmeeintrags von der oberen Heizplatte, in Verbindung mit einer wahlweise vorgesehenen unteren Heizplatte, schnell und energiesparend auf die Vernetzungstemperatur bzw. Schmelztemperatur gebracht werden. Die Versiegelung erfolgt dabei durch das Laminieren selbst.

Die Dicke des Substrats kann im Fall von Steinplatten bis zu 5 cm, bevorzugt bis zu 2 cm betragen. Bei Substraten geringerer Dichte wie zum Beispiel Holzsubstraten sind auch Dicken bis 10 cm möglich. Obwohl aufgrund des Wärmeeintrags von oben und der dadurch bewirkten Unabhängigkeit von der Wärmeleitfähigkeit des Substrats durchaus auch größere Substratdicken denkbar wären, ist in der Praxis das Flächengewicht des Substrats durch die Tragfähigkeit der Anpressmembran begrenzt, kann aber dabei bis zu 9 t/m² betragen. Ein derartig hohes Gewicht des Substrats kann problemlos mit der Anpressmembran der erfindungsgemäßen Laminationsvorrichtung angehoben werden und wirkungsvoll verpresst werden. Sollten dennoch höhere Flächengewichte zum Einsatz kommen, kann als Anpressmembran eine mit Gittergewebe verstärkte Silikonmembran verwendet werden.

In einer alternativen Ausgestaltung kann das Substrat aber auch nicht poröse Materialien mit geringer Wärmeleitfähigkeit (<3,5 W/(m·K)), beispielsweise Gummi oder Holz und holzartige Werkstoffe umfassen, die ebenfalls schnell und energiesparend auf Vernetzungstemperatur gebracht werden.

Die Deckschicht kann Glas, beispielsweise Fensterglas oder andere, beispielsweise hochreine Silikatgläser, oder alternativ eine transparente Front-Sheet-Folie beispielsweise aus ETFE, FEP, Polycarbonat (PC) oder TEDLAR^{®} umfassen.

In einer weiteren Ausgestaltung umfasst das laminierte Produkt zwischen der Deckschicht und dem Substrat einen Photovoltaik-Zellen-Verbund, der zwischen der Deckschicht und dem Substrat durch Lamination verpresst ist. Die elektrische Verschaltung des Photovoltaik-Zellen-Verbundes wird dabei vorzugsweise an der diesem abgewandten Seite oder an den Schmalseiten des Substrats herausgeführt. Weiter ist bevorzugt sowohl zwischen Deckschicht und Photovoltaik-Stapel sowie zwischen Photovoltaik-Stapel und Substrat eine schmelzbare oder/und vernetzende Laminationsfolie vorgesehen.

Als Alternative oder zusätzlich zum Photovoltaik-Zellen-Verbund kann auch mindestens ein lichtemittierendes Bauteil, beispielsweise ein OLED-Verbund, im Bauteilestapel vorgesehen sein. Wenn dieses Bauteil zusätzlich vorgesehen ist, so ist es denkbar, dass der Photovoltaik-Zellen-Verbund und das lichtemittierende Bauteil auf der Substratoberfläche nebeneinander liegen oder sich abwechseln.

Zwischen das Substrat und die Schichtenfolge von Laminationsfolie(n) und Photovoltaik-Zellen-Verbund bzw. lichtemittierendem Bauteil kann eine transparente Dampf- oder Diffusionssperre zwischengelegt werden. Diese Dampf- oder Diffusionssperre ist beispielsweise eine zusätzliche Folie und verhindert insbesondere bei besonders porösen Substraten, dass von der Rückseite (d.h. jener der Sichtseite abgewandten Seite) des Substrats her Wasser eindringen kann. Dieses Wasser kann ansonsten die Laminationsfolien (zum Beispiel aus EVA) degradieren und somit die Verkapselung zerstören. Diese zusätzliche Folie besteht beispielsweise aus ETFE, PC oder TEDLAR^{®}, und kann selbst schmelzbar sein oder mit einer schmelzbaren Beschichtung versehen sein, die ihrer Haftung am Substrat dient. Auch eine Glasscheibe wäre als Diffusionssperre einsetzbar.

Dieses Produkt ist besonders für das Baugewerbe von Vorteil, da es die abschließende Verkleidung von Wänden, Dächern, Fußböden (z.B. auf der Terrasse) mit Substraten ermöglicht, die einerseits aufgrund ihrer geringen Wärmeleitfähigkeit (<3,5 W/(m·K)) isolierend und somit energiesparend wirken und die andererseits zur Stromerzeugung durch die Photovoltaik-Elemente eingesetzt werden können. Außerdem kann auf die bisher notwendigen aufwändigen Halte- bzw. Montageeinrichtungen, mit denen Photovoltaik-Module auf Substraten wir zum Beispiel Wandverkleidungen oder Dachbedeckungen montiert waren, verzichtet werden, was nicht nur in Bezug auf Materialaufwand sondern auch hinsichtlich der nötigen Arbeitszeit enorm Kosten spart. Die Verwendung von beliebigen Steinmaterialien als Substrat erlaubt zudem, die Verkleidung auch unter ästhetischen Gesichtspunkten attraktiv zu gestalten.

Durch Verwendung der erfindungsgemäßen Vorrichtung bzw. des erfindungsgemäßen Verfahrens kann bei solchen laminierten Produkten insbesondere die Gefahr der Bildung von Blasen eliminiert werden, deren Vorhandensein bzw. deren Platzen die Unbrauchbarkeit des Photovoltaik-Moduls zur Folge hat.

Die schmelzbaren Laminationsfolien umfassen dabei insbesondere PVB-, Silikon, EVA- und TPU-Folien, die als aufschmelzende oder vernetzende oder fügende Kunststoffe eingesetzt werden. Das Material der schmelzbaren Laminationsfolie ist aber nicht auf die hier genannten Materialien beschränkt, es können alle geeigneten Kunststoffe verwendet werden, die eine für die effiziente, sämtliche Hohlräume füllende Verschmelzung notwendige Viskosität besitzen. Insgesamt eröffnet das laminierte Produkt weite Einsatzbereiche, so zum Beispiel als Granit- oder Fließenverkleidung in Duschkabinen, als besonders strapazierfähiger und haltbarer Fußboden auf Basis von Stein oder Holz(laminat), oder als Solarverkleidungsmodul für den Außenbereich von Gebäuden.

### Kurze Beschreibung der Zeichnungen

Figur 1 ist eine schematische seitliche Schnittansicht einer Laminationsvorrichtung gemäß einer Ausführungsform der Erfindung;
Figuren 2a) bis 2c) sind jeweils vergrößerte Ausschnitte der Figur 1 und zeigen eine weitere Ausführungsform der Laminationsvorrichtung der Erfindung, wobei die Figuren 2a) bis c) verschiedene Prozessstadien veranschaulichen;
Figur 3a) ist eine perspektivische Schnittansicht eines Dichtrahmens gemäß einer weiteren Ausführungsform der Erfindung;
Figur 3b) ist eine Draufsicht einer Ausführungsart des Dichtrahmens; und
Figur 4a) ist eine schematische Draufsicht auf eine Presskammer des Stands der Technik und
Figur 4b) ist eine schematische Draufsicht auf eine Presskammer mit einem erfindungsgemäßen Dichtrahmen.
Figuren 5a) und 5b) sind schematische Schnittansichten eines Beispiels eines Bauteilestapels bzw. eines fertigen laminierten Produkts.

### Wege zur Ausführung der Erfindung

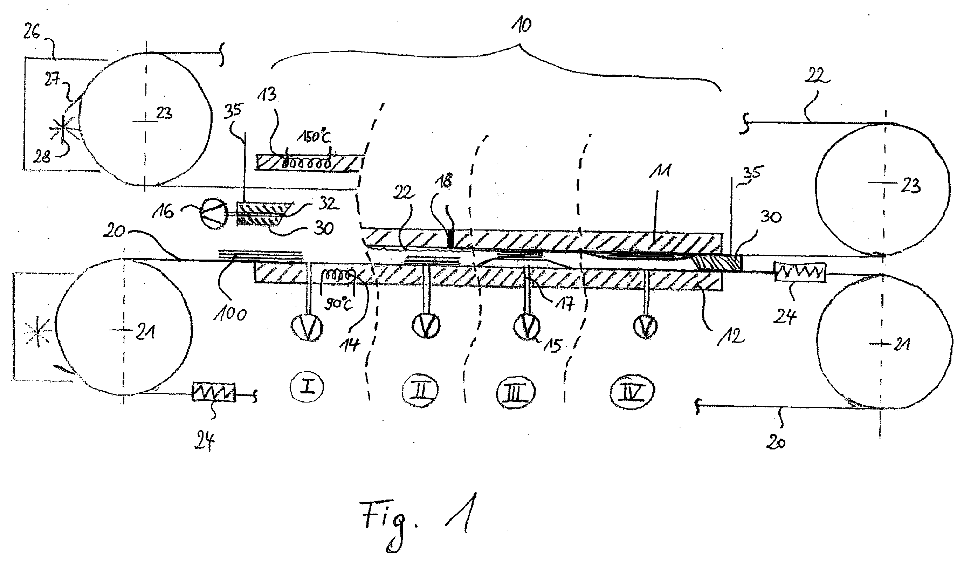

In Figur 1 ist eine schematische seitliche Schnittansicht einer Ausführungsform einer erfindungsgemäßen Laminationsvorrichtung während vier Stadien (I) bis (IV) des Laminationsvorgangs gezeigt. Die Laminationsvorrichtung umfasst mindestens eine Presskammer, die von einer oberen Kammerwand 11 und einer unteren Kammerwand 12 begrenzt wird. In der oberen Kammerwand 12 ist eine Heizplatte 13 integriert, während in der unteren Kammerwand 12 eine Vorwärmplatte 14 integriert ist. Beide Platten 13 und 14 sind in Fig.1 der Einfachheit halber nur im dem Stadium (I) entsprechenden Zeichnungsteil dargestellt ist.

Zwischen den Kammerwänden verläuft im oberen Kammerteil ein als Endlosband ausgestaltetes Releasesheet 22, das über Rollen 23 umlaufend bewegt wird. Das Releasesheet nimmt, wie eingangs erwähnt, Laminationsrückstände auf und transportiert sie aus der Kammer ab. Zur definitiven Entfernung der Rückstände ist außerhalb der Kammer eine mechanische Reinigungseinrichtung 26 vorgesehen, die aus einem Schaber 27 und einer rotierenden Bürste 28 besteht.

Im unteren Kammerteil läuft eine Anpressmembran 20 durch die Presskammer 10, welche Bauteilestapel 100, von denen nur einer in Fig.1 dargestellt ist, in die Presskammer ein- und aus ihr ausfördert. Die Anpressmembran 20 ist im vorliegenden Ausführungsbeispiel auch als Endlosband ausgestaltet, das zum Beispiel an einem Kettentrieb (nicht näher gezeigt) eingespannt und über Antriebsrollen 21 bewegt wird. Die Anpressmembran ist im vorliegenden Ausführungsbeispiel zudem durch Spannvorrichtungen 24 vorgespannt.

Zwischen der Anpressmembran 20 und dem Releasesheet 22 befindet sich um den Rand der Presskammer umlaufend ein Dichtrahmen 30, der die Kammer im geschlossenen Zustand nach außen abdichtet. Der Rahmen kann bevorzugt mithilfe einer in Fig. 1 nur angedeuteten Schnellspanneinrichtung 35 schnell wechselbar eingespannt sein. An der unteren Kammerwand sind Öffnungen bzw. Kanäle 17 vorgesehen, an die Vakuumpumpen 15 angeschlossen sind, welche den unter der Anpressmembran liegenden Kammerteil evakuieren, belüften oder mit Druck beaufschlagen können. Weiter ist eine Vakuumpumpe 16 über Belüftungslöcher 32 im Dichtrahmen 30 mit dem über der Anpressmembran 20 liegenden Kammerteil verbunden und kann letzteren evakuieren, belüften oder mit Druck beaufschlagen. In der oberen Kammerwand 11 hingegen ist ein Thermosensor 18 vorgesehen, wie zum Beispiel ein Thermoelement, das die Temperatur der Heizplatte 13 bzw. oberen Kammerwand 11 messen kann, oder ein IR-Thermometer, das durch Messung der Wärmestrahlung des Bauteilestapels direkt dessen Temperatur ermitteln kann. Bei letzterem muss das Releasesheet 22 entweder für den fraglichen IR-Wellenlängenbereich transparent sein oder geeignete Fenster aufweisen. Da sämtliche Anschlüsse des Thermosensors außerhalb der Kammer liegen, kann auch ein einfacher Mechanismus zum Einstellen der Höhe der Sensorspitze in der Kammer vorgesehen werden, zum Beispiel mittels eines Schraubengewindes. Ferner können in der oberen Kammerwand Abstandmesser (nicht gezeigt) vorgesehen sein, wie zum Beispiel Ultraschall-Abstandsmesser oder Messstifte, die die Höhe der Bauteilestapel in der Kammer bestimmen können.

Im Betrieb werden die Bauteilestapel 100 in Phase (I) auf der als Endlosband ausgestalteten Anpressmembran 20 in die Presskammer 10 eingefahren, wobei sie auf der mit der Vorwärmplatte 14 ausgestattete untere Kammerwand 12 zu liegen kommen. Diese Vorwärmplatte 14 bringt den Bauteilestapel auf einer Vorwärmtemperatur von beispielsweise 90°C, welche ausreichend niedriger als die Vernetzungstemperatur (ca. 150°C) ist und somit noch keine chemischen Reaktionen im Bauteilestapel auslöst. Gleichzeitig aber verringert sie die in den nachfolgenden Schritten zum Erhitzen auf Vernetzungstemperatur benötigte Zeit und verringert somit die Prozesszeiten.

In Phase (II) wird die Presskammer 10 nun druckdicht verschlossen, und der obere und untere Kammerteil werden mithilfe der Pumpen 15 und 16 evakuiert, wodurch eventuell zwischen den Bauteilestapeln vorhandene Luft entfernt wird. Es wird beispielsweise ein Unterdruck von 1 mbar eingestellt, der aufgrund der geringen Kammerabmessungen in kürzester Zeit, beispielsweise in weniger als 1 Minute, erreicht wird. Gleichzeitig wird der Bauteilestapel 100 weiter von der Vorwärmplatte 14 vorgewärmt.

Sind der gewünschte Unterdruck und/oder die gewünschte Vorwärmtemperatur erreicht, wird in Phase (III) der untere, unter der Anpressmembran 20 liegende Kammerteil belüftet. Dadurch wird die Anpressmembran 20 aufgrund der Druckdifferenz zum oberen Kammerteil nach oben gezogen und hebt dabei den Bauteilestapel 100 an. Durch gezieltes Steuern der Belüftung des unteren Kammerteils ist es möglich, das Anheben der Anpressmembran 20 so zu steuern, dass die Bauteilestapel 100 auf eine beliebige Höhe zwischen oberer und unterer Kammerwand gebracht werden können. Hierzu ist es beispielsweise möglich, die Höhe der Stapel 100 durch die genannten Abstandsmessvorrichtungen zu bestimmen und mit der Unterdrucksteuerung des unteren Kammerteils einen Regelkreis auszubilden. Diese Höhensteuerung, die somit den Abstand des Bauteilestapels 100 von der oberen beheizten Kammerwand 11 einstellt, ermöglicht es beispielsweise, die Bauteilestapel 100 gemäß einem gegebenen Temperaturprofil an die Vernetzungstemperatur heranzuführen, also sanfter zu erhitzen, was sich positiv auf das Laminationsergebnis auswirkt.

Schließlich wird in Phase (IV) die Belüftung des unteren Kammerteils auf Atmosphärendruck gebracht, wodurch die Anpressmembran 20 den Bauteilestapel 100 mit dem darüberliegenden Releasesheet 22 gegen die obere Kammerwand 11 presst, wodurch Kombination von Anpressdruck und Wärmeeintrag der beheizten oberen Kammerwand 11 die Vernetzung und Verpressung der Bauteilestapel bewirkt.

Nach Vernetzung wird der obere Kammerteil belüftet, der untere Kammerteil wird ebenso belüftet, und der verpresste und vernetzte Bauteilestapel wird durch Eigengewicht auf die untere Kammerwand zurückgebracht (in Fig. 1 nicht gezeigt). Dabei kann der Stapel durch eine optional in der unteren Kammerwand vorgesehene Kühlplatte (nicht gezeigt) abgekühlt werden, bevor die Bauteilestapel nach Öffnen der Presskammer 10 auf der Anpressmembran 20 aus dieser ausgefördert werden.

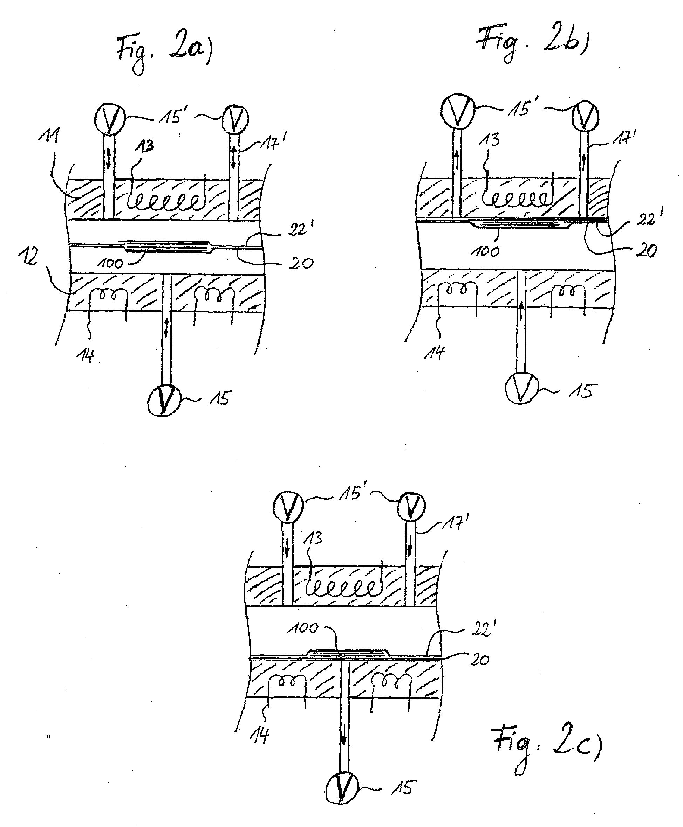

Gemäß einer weiteren Ausführungsform ist das Releasesheet gasdicht ausgestaltet, wie es in Fig. 2a) bis c) schematisch gezeigt ist, und es ist dadurch möglich, den oberen, nun vom gasdichten Releasesheet 22' gebildeten Kammerteil mithilfe von Pumpen 15', die über Öffnungen 17' in der oberen Kammerwand mit dem oberen Kammerteil verbunden sind, ebenfalls zu belüften oder zu evakuieren. Durch Einstellen eines geeigneten Drucks im unteren Kammerteil ist es somit möglich, den Bauteilestapel 100 zwischen gasdichtem Releasesheet 22' und Anpressmembran 20 auf eine beliebige Höhe innerhalb der Presskammer zu heben und zu halten (Fig. 2a), wie beispielsweise während eines langsamen Erhitzens. Zuvor oder währenddessen wird der mittlere Kammerteil evakuiert, um so die Bauteilestapel zusammenzupressen. Wird dann der obere Kammerteil evakuiert und der untere belüftet, presst die Anpressmembran 20 den Bauteilestapel 100 gegen die obere, von der Heizvorrichtung 13 auf Vernetzungstemperatur erhitzte Kammerwand, und der Bauteilestapel wird vernetzt und verpresst (Fig. 2b). Nach dem Verpressen wird der obere Kammerteil belüftet und der mittlere und untere evakuiert, wodurch das gasdichte Releasesheet 22' die Bauteilestapel 100 gegen die untere Kammerwand drückt, wo sie mithilfe der Vorwärmvorrichtung 14, die eine wesentlich niedrigere Temperatur als die Heizvorrichtung 13 aufweist, gekühlt werden (Fig. 2c).

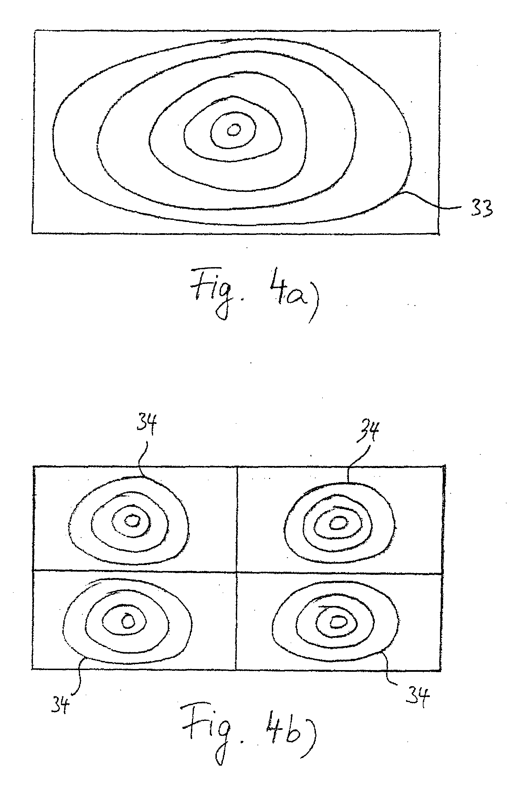

Die Evakuierung und Belüftung, also die Ausbildung von Druckgradienten (z.B. von 1013 mbar auf 1 mbar) gegenüber der Außenseite der Presskammer bringt natürlich hohe Belastungen der Kammerwände mit sich, die also entsprechend stark ausgeführt oder versteift werden müssen. Zudem ist bei Belüftung der unteren Kammer die Verformung der Anpressmembran ballonförmig und verpresst deshalb zunächst den mittleren Bereich der Heizfläche. Diese ungleichmäßige Verformung geht einher mit einem ungleichmäßigen Anpressdruck und somit mit einer ungleichmäßigen Vernetzung der Bauteilestapel abhängig von deren Position in Bezug auf die Kammermitte. Diese Druckverteilung 33 ist schematisch in Fig. 4a) gezeigt.

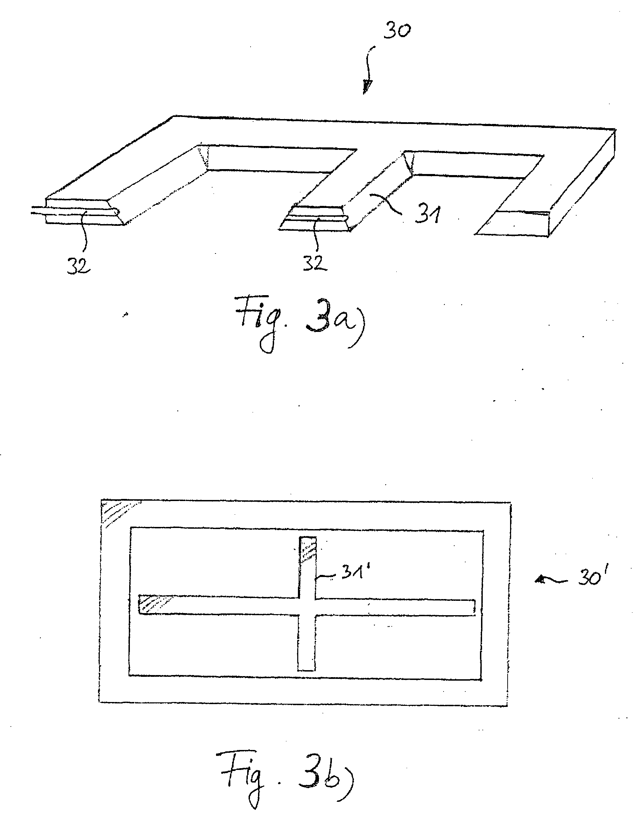

In einer bevorzugten Ausführungsform der Erfindung ist hierzu der Dichtrahmen 30 mit mindestens einer Strebe als länglichem Abstandselement 31 ausgestaltet, wie es in Fig. 3a) im Querschnitt zu sehen ist. Die Dichtstrebe ist in dem Ausführungsbeispiel gemäß Fig. 3a) ganzheitlich bzw. einstückig mit dem umlaufenden Dichtrahmen 30 ausgebildet. Es können beispielsweise zwei überkreuzte Streben 31 vorgesehen sein, die mit dem Dichtrahmen ein Dichtrahmenkreuz bilden. Die Strebe(n) 31' kann (können) alternativ aber auch separat vom Dichtrahmen 30' ausgebildet sein, d.h. der oder die Streben 31' sind nicht oder nur über Zwischenstücke mit dem Dichtrahmen 30' verbunden, wie es in Fig. 3b) gezeigt ist. Wesentlich ist bei allen genannten Ausgestaltungen des Dichtrahmens und der Strebe(n), dass der zwischen der Anpressmembran und dem Releasesheet vorhandene, die Bauteilestapel 100 aufnehmende Raum strukturell unterteilt wird, um so die aufgrund der Evakuierung entstehende Belastung gleichmäßig auf die obere und untere Presskammerwand zu verteilen und gleichzeitig für ein ebeneres Aufliegen und Anpressen der Anpressmembran auf den Bauteilestapeln zu sorgen. Dadurch wird eine über die Presskammerfläche gleichmäßigere Druckverteilung 34 erzielt, wie es in Fig. 4b) für ein Dichtrahmenkreuz, beispielsweise nach Fig. 3b), gezeigt ist.

Der Dichtrahmen 30 und die Dichtstrebe(n) 31 besitzen im gezeigten Ausführungsbeispiel eine oder mehrere seitlich durch sie hindurchgehende Durchbohrungen oder Belüftungslöcher auf, durch welche eine Evakuierung bzw. Belüftung oder Druckbeaufschlagung der einzelnen Unterteilungen des die Bauteilestapel 100 aufnehmenden Raums erfolgt. Dabei ist ein Belüftungsloch 32 im umlaufenden Dichtrahmen 30 mit der Vakuumpumpe 16 verbunden, die wie oben besprochen den Unterdruck bzw. die Belüftung im oberen Kammerteil (die Bauteilestapel aufnehmenden Raum) erzeugt.

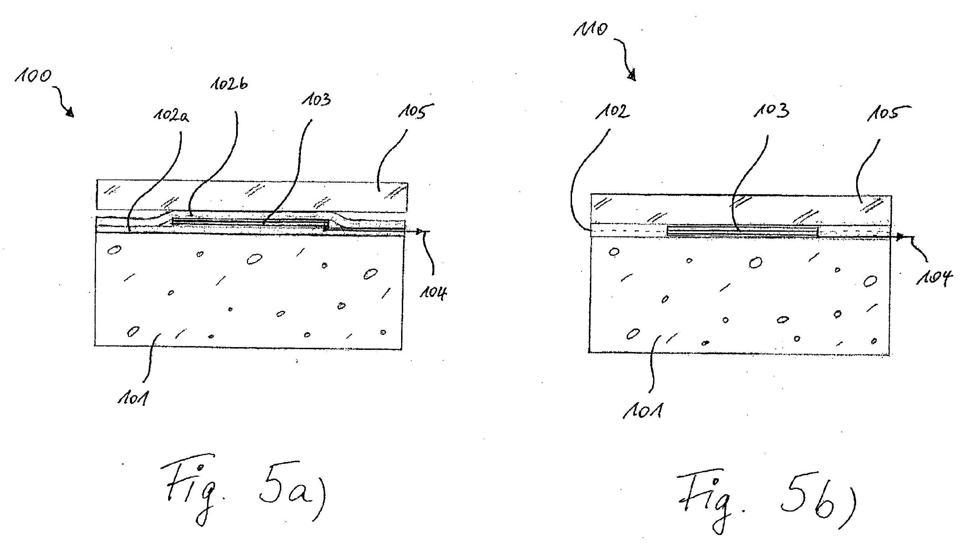

In Fig. 5b schließlich ist ein Ausführungsbeispiel eines laminierten Produkts gezeigt, das mit der oben beschriebenen Laminationsvorrichtung und dem zugehörigen Verfahren aus einem Bauteilestapel 100 herstellbar ist. Das laminierte plattenförmige Produkt ist hierbei eine Solarverbund-Verkleidungsmodul 110 und umfasst eine 2 cm dicke Marmorplatte als Substrat 101, auf welcher ein Photovoltaik-Zellen-Verbund 103 auflaminiert und mit einer Deckschicht 105 aus Glas verkapselt ist. Die Laminierung bzw. Verkapselung erfolgt unter Zwischenlegen einer schmelzbaren und/oder vernetzenden Laminationsfolie 102a, 102b aus Ethylen-VinylAcetat (EVA) sowohl zwischen Marmorsubstrat 101 und Photovoltaik-Zellen-Verbund 103 als auch zwischen Photovoltaik-Zellen-Verbund 103 und Deckschicht 105. Das Marmorsubstrat 101 besitzt eine geringe Wärmeleitfähigkeit von etwa 2,8 W/(m·K).

Wie oben bereits ausgeführt wurde, wird zu Beginn des Laminationsprozesses der Bauteilestapel 100, der in Fig. 5a dargestellt ist und vorliegend das Marmorsubstrat 101, eine erste EVA-Folie 102a, den Photovoltaik-Zellen-Verbund 103, eine zweite EVA-Folie 102b und die Glas-Deckschicht 105 umfasst, auf unter die Schmelztemperatur vorgewärmt, wobei die vorgewärmte Presskammer gründlich evakuiert wird und damit sämtliche Lufteinschlüsse verhindert werden. Nach Anheben des Bauteilestapels 100 durch die Anpreßmembran und Temperaturerhöhung auf die Verschmelzungs- bzw. Vernetzungstemperatur werden durch den darauf folgenden Wärmeeintrag von oben die Laminationsfolien 102a, 102b mit dem Substrat 101, dem Photovoltaik-Zellen-Verbund 103 und dem Deckglas 105 verschmolzen und so das laminierte Produkt 110 erzeugt, wobei eine dauerhafte physikalische Haftung der jeweiligen Schichten miteinander gegeben ist.

Wie aus der Schnittzeichnung der Fig. 5a und 5b ersichtlich ist, sind die elektrischen Anschlüsse 104 des Photovoltaik-Moduls 103 seitlich, das heißt an den Schmalseiten der Platte 110, zwischen Deckschicht 105 und Marmorsubstrat 101 herausgeführt. Der Photovoltaik-Zellen-Verbund 103 bedeckt dabei nur einen Teil der Oberfläche des Marmorsubstrats 101, so dass auf dem Rest der Oberfläche die Struktur bzw. Maserung des Marmors sichtbar bleibt und dieses somit seinen ästhetischen Effekt nicht einbüßt. Gleichzeitig kann dadurch der Photovoltaik-Zellen-Verbund 103 absolut luft- und witterungsdicht eingekapselt werden, da die Seiten und Oberflächen des Verbunds nicht nur von oben und unten durch Substrat 101 und Deckschicht 105, also senkrecht zur Erstreckungsrichtung des laminierten Produkts, sondern auch seitlich in einer Entfernung von den Rändern des Substrats 101 durch die Verschmelzung der beiden Laminationsfolien 102a, 102b eingekapselt sind. Dies ist gut in Fig. 5b zu sehen, in welcher die Folien 102a und 102b entlang einer Verschmelzungsfläche, die nach der Laminierung nicht mehr sichtbar und deshalb gestrichelt dargestellt ist, zu einer Einkapselung 102 verschmolzen sind. Dies führt, in Verbindung mit der strukturellen Festigkeit, die von der Marmorplatte 101 sowie dem Deckglas 105 gewährt werden, zu einer sehr großen Lebensdauer der Module 110 von 20 Jahren und mehr, die aber gleichzeitig aufgrund des schnellen und effizienten Herstellungsvorgangs nicht mit erhöhten Kosten einhergeht.

Zusammenfassend erlaubt die erfindungsgemäße Laminationsvorrichtung somit eine Verringerung der Baugröße der Presskammer sowie der Dicke oder Versteifung der Kammerwände, was zu erheblichen Gewichtseinsparungen führt, so dass bei der erfindungsgemäßen Laminationsvorrichtung von Leichtbauweise gesprochen werden kann. Diese Einsparungen werden durch den möglich werdenden Verzicht auf eine separate Heizplatte und auf Stifthubeinrichtungen noch erhöht. Durch bessere Anpresseigenschaften in Bezug auf Gleichmäßigkeit und Temperatureinbringung wird zudem das Laminationsergebnis stark verbessert. Geringere Prozesszeiten und Energieaufwendungen bzw. rückgewonnene Wärmeenergie können bis zu 30% an Kosten gegenüber dem bekannten Stand der Technik sparen. Weiterhin ist es möglich, aufgrund der genannten Leichtbauweise nun mehrere Presskammern übereinander als Etagenpressen anzuordnen. Die vorliegende Erfindung ist aber nicht durch die in den Ausführungsformen genannten Merkmale beschränkt, und wird in ihrem Schutzbereich durch die folgenden Ansprüche definiert.

## Patentansprüche

1. Laminationsvorrichtung zum Laminieren von Stapeln (100) von Bauteilen, wobei die Laminationsvorrichtung mindestens eine luftdicht verschließbare, eine obere (11) und eine untere (12) Kammerwand umfassende und mit mindestens einer Heizvorrichtung (13) ausgestattete Presskammer (10) zur Aufnahme eines oder mehrerer Bauteilestapel (100) sowie ein oberhalb der Bauteilestapel vorgesehenes Releasesheet (22, 22') umfasst,
**dadurch gekennzeichnet, dass**
die Laminationsvorrichtung eine flexible Anpressmembran (20) umfasst, auf der der mindestens eine Bauteilestapel (100) von der unteren Kammerwand (12) abhebbar aufgenommen wird,
wobei unter der Anpressmembran (20) ein unterer Kammerteil und über ihr ein oberer Kammerteil ausgebildet ist, die jeweils belüftbar und evakuierbar sind.

2. Laminationsvorrichtung nach Anspruch 1, wobei die Heizvorrichtung (13) in der oberen Wand (11) der Presskammer (10) angeordnet ist.

3. Laminationsvorrichtung nach Anspruch 1 oder 2, wobei die Anpressmembran (20) und/oder das Releasesheet (22, 22') als durch die Presskammer (10) laufendes Endlosband ausgebildet ist.

4. Laminationsvorrichtung nach Anspruch 3, wobei die Anpressmembran (20) und das Releasesheet (22, 22') jeweils einzeln oder zusammen vorspannbar sind.

5. Laminationsvorrichtung nach einem der vorangehenden Ansprüche, wobei in oder an der unteren Kammerwand (12) eine Kühlvorrichtung und/oder eine Vorwärmvorrichtung (14) angeordnet ist.

6. Laminationsvorrichtung nach einem der Ansprüche 1 bis 5, wobei das Releasesheet (22') gasdicht ausgebildet ist und mit der Anpressmembran (20) einen mittleren Kammerteil definiert, der belüftbar und evakuierbar ist.

7. Laminationsvorrichtung nach einem der Ansprüche 1 bis 5, wobei über dem Releasesheet (22) eine obere Membran angeordnet ist, die mit der Anpressmembran (20) einen mittleren Kammerteil definiert, der belüftbar und evakuierbar ist.

8. Laminationsvorrichtung nach einem der vorangehenden Ansprüche, wobei zwischen der oberen und unteren Kammerwand ein die Kammer randseitig umlaufender Dichtrahmen (30, 30') vorgesehen ist, wobei innerhalb des Dichtrahmens mindestens ein im Wesentlichen parallel zu den Kammerwänden (11, 12) verlaufendes Abstandselement (31, 31') vorgesehen ist, das den von Dichtrahmen (30), Releasesheet (22, 22') und Anpressmembran (20) gebildeten Raum teilweise oder vollständig in Unterbereiche unterteilt.

9. Laminationsvorrichtung nach Anspruch 8, wobei das mindestens eine Abstandselement (31) mit dem Dichtrahmen einstückig ausgebildet ist.

10. Laminationsvorrichtung nach Anspruch 8 oder 9, wobei das mindestens eine Abstandselement (31, 31') den von Dichtrahmen (30, 30'), Releasesheet (22, 22') und Anpressmembran (20) gebildeten Raum in gleich große Unterbereiche unterteilt.

11. Laminationsvorrichtung nach Anspruch 8, 9 oder 10, wobei im Dichtrahmen (30, 30') und/oder in dem mindestens einen Abstandselement (31, 31') mindestens eine durchgehende Belüftungsöffnung (32) vorgesehen ist, durch welche die zwischen Releasesheet (22, 22') und Anpressmembran (20) befindlichen Unterbereiche im geschlossenen Zustand belüftet bzw. evakuiert werden können.

12. Verfahren zum Laminieren von Stapeln (100) von Bauteilen, umfassend die folgenden Schritte:
Einführen mindestens eines Bauteilestapels (100) in eine Presskammer (10) mit einer oberen und einer unteren Kammerwand (11, 12), in der eine Anpressmembran (20) und über ihr ein Releasesheet (22, 22') angeordnet sind, die den mindestens einen Bauteilestapel (100) von der unteren Kammerwand (12) abhebbar zwischen sich aufnehmen,
druckdichtes Verschließen der Presskammer (100),
Evakuieren des über und/oder unter der Anpressmembran (20) liegenden Presskammerteils,
Belüften oder mit Druck Beaufschlagen des unter der Anpressmembran (20) liegenden Presskammerteils,
wodurch der mindestens eine Bauteilestapel (100) von der unteren Kammerwand (12) abgehoben, an die obere Kammerwand (11) gedrückt und durch Hitzeeinwirkung von oben verpresst wird.

13. Verfahren nach Anspruch 12, wobei die Anpressmembran (20) und/oder das Releasesheet (22, 22') jeweils als Endlosband ausgestaltet sind und durch die Presskammer (10) laufen, und die Anpressmembran (20) geeignet ist, den Bauteilestapel (100) in die Presskammer (10) zu fördern.

14. Verfahren nach einem der Ansprüche 12 bis 13, wobei der mindestens eine Bauteilestapel (100) nach Einführen in die Presskammer (10) zunächst auf eine Aufwärmtemperatur erwärmt wird, und dann während des Schritts des Andrückens an die obere Kammerwand (11) auf eine Vernetzungstemperatur erhitzt wird, wobei die Vernetzungstemperatur höher als die Aufwärmtemperatur ist.

15. Verfahren nach einem der Ansprüche 12 bis 14, wobei der Schritt des Belüftens oder mit Druck Beaufschlagens einen ersten Teilschritt umfasst, bei dem die Anpressmembran (20) den mindestens einen Bauteilestapel (100) auf eine von der oberen und der unteren Kammerwand (11, 12) beabstandete Position anhebt und dort hält, und einen darauf folgenden zweiten Teilschritt umfasst, bei dem der mindestens eine Bauteilestapel (100) an die obere Kammerwand (11) gedrückt und durch Hitzeeinwirkung von oben verpresst wird.

16. Verfahren nach einem der Ansprüche 12 bis 15, wobei das Releasesheet (22') gasdicht ausgebildet ist oder über dem Releasesheet (22) eine obere Membran vorgesehen ist, um mit der Anpressmembran (20) einen mittleren Kammerteil zu definieren, und nach dem Schritt des Verpressens der mindestens eine Bauteilestapel (100) durch Belüften oder mit Druck Beaufschlagen des oberen und/oder mittleren Kammerteils und Evakuieren des unteren Kammerteils mithilfe des gasdichten Releasesheets (22') oder der oberen Membran gegen die untere, eine Kühlvorrichtung und/oder eine Vorwärmvorrichtung (14) umfassende Presskammerwand (12) gedrückt und so abgekühlt wird.

## Claims

1. Laminating apparatus for laminating stacks (100) of structural elements, wherein the laminating apparatus comprises at least one pressing chamber (10) which can be sealed airtight, which comprises an upper (11) and a lower (12) chamber wall and which is fitted with at least one heating device (13), for receiving one or more stacks (100) of structural elements, as well as a release sheet (22, 22') provided above the stacks of structural elements,
**characterised in that**
the laminating apparatus comprises a flexible pressure diaphragm (20) on which is held the at least one stack (100) of structural elements so that it can be lifted off the lower chamber wall (12),
wherein below the pressure diaphragm (20) is formed a lower chamber part and above it an upper chamber part, which in each case can be ventilated and evacuated.

2. Laminating apparatus according to claim 1, wherein the heating device (13) is arranged in the upper wall (11) of the pressing chamber (10).

3. Laminating apparatus according to claim 1 or 2, wherein the pressure diaphragm (20) and/or the release sheet (22, 22') is designed as an endless belt running through the pressing chamber (10).

4. Laminating apparatus according to claim 3, wherein the pressure diaphragm (20) and the release sheet (22, 22') are in each case prestressable individually or together.

5. Laminating apparatus according to any of the preceding claims, wherein in or on the lower chamber wall (12) is arranged a cooling device and/or a preheating device (14).

6. Laminating apparatus according to any of claims 1 to 5, wherein the release sheet (22') is gastight and with the pressure diaphragm (20) defines a central chamber part which can be ventilated and evacuated.

7. Laminating apparatus according to any of claims 1 to 5, wherein above the release sheet (22) is arranged an upper diaphragm which with the pressure diaphragm (20) defines a central chamber part which can be ventilated and evacuated.

8. Laminating apparatus according to any of the preceding claims, wherein between the upper and lower chamber walls is provided a sealing frame (30, 30') which runs around the edge of the chamber, wherein within the sealing frame is provided at least one spacer element (31, 31') which runs substantially parallel to the chamber walls (11, 12) and which partly or completely divides the space formed by sealing frame (30), release sheet (22, 22') and pressure diaphragm (20) into subregions.

9. Laminating apparatus according to claim 8, wherein the at least one spacer element (31) is constructed in one piece with the sealing frame.

10. Laminating apparatus according to claim 8 or 9, wherein the at least one spacer element (31, 31') divides the space formed by sealing frame (30, 30'), release sheet (22, 22') and pressure diaphragm (20) into subregions of equal size.

11. Laminating apparatus according to claim 8, 9 or 10, wherein in the sealing frame (30, 30') and/or in the at least one spacer element (31, 31') is provided at least one through-opening (32) for ventilation, through which the subregions located between release sheet (22, 22') and pressure diaphragm (20) can be ventilated or evacuated in the closed state.

12. Method for laminating stacks (100) of structural elements, comprising the following steps:
introducing at least one stack (100) of structural elements into a pressing chamber (10) having an upper and a lower chamber wall (11, 12), in which are arranged a pressure diaphragm (20) and, above it, a release sheet (22, 22'), which receive between them the at least one stack (100) of structural elements so that it can be lifted off the lower chamber wall (12),
pressure-tightly closing the pressing chamber (100),
evacuating the pressing chamber part located above and/or below the pressure diaphragm (20),
ventilating or pressurising the pressing chamber part located below the pressure diaphragm (20),
as a result of which the at least one stack (100) of structural elements is lifted off the lower chamber wall (12), pressed against the upper chamber wall (11) and compressed from above by the action of heat.

13. Method according to claim 12, wherein the pressure diaphragm (20) and/or the release sheet (22, 22') are in each case designed as an endless belt and run through the pressing chamber (10), and the pressure diaphragm (20) is fit to convey the stack (100) of structural elements into the pressing chamber (10).

14. Method according to either of claims 12 to 13, wherein the at least one stack (100) of structural elements is initially heated to a warm-up temperature after being introduced into the pressing chamber (10), and then heated to a crosslinking temperature during the step of pressing against the upper chamber wall (11), wherein the crosslinking temperature is higher than the warm-up temperature.

15. Method according to any of claims 12 to 14, wherein the step of ventilation or pressurisation comprises a first partial step in which the pressure diaphragm (20) lifts the at least one stack (100) of structural elements to a position at a distance from the upper and lower chamber walls (11, 12) and holds it there, and a subsequent second partial step in which the at least one stack (100) of structural elements is pressed against the upper chamber wall (11) and compressed from above by the action of heat.

16. Method according to any of claims 12 to 15, wherein the release sheet (22') is gastight or above the release sheet (22) is provided an upper diaphragm in order to define with the pressure diaphragm (20) a central chamber part, and after the compression step the at least one stack (100) of structural elements is pressed against the lower pressing chamber wall (12) which comprises a cooling device and/or a preheating device (14) by ventilation or pressurisation of the upper and/or central chamber part and evacuation of the lower chamber part by means of the gastight release sheet (22') or the upper diaphragm, and in this way is cooled.

## Revendications

1. Dispositif de laminage pour le laminage de piles (100) de composants, ledit dispositif de laminage comprenant au moins une chambre de compression (10) pouvant être fermée de manière étanche à l'air, comportant une paroi de chambre supérieure (11) et une paroi de chambre inférieure (12), et pourvue d'au moins un dispositif de chauffage (13), pour la réception d'une ou de plusieurs piles de composants (100), ainsi qu'une feuille détachable (22, 22') prévue au-dessus de la pile de composants,
**caractérisé en ce que**
ledit dispositif de laminage comprend une membrane de pressage (20) flexible, sur laquelle sont reçues la ou les piles de composants (100) pouvant être soulevées de la paroi de chambre inférieure (12),
une partie de chambre inférieure étant formées en dessous de la membrane de pressage (20), et une partie de chambre supérieure au-dessus de celle-ci, lesquelles peuvent respectivement être aérées et mises sous vide.

2. Dispositif de laminage selon la revendication 1, où le dispositif de chauffage (13) est monté dans la paroi supérieure (11) de la chambre de compression (10).

3. Dispositif de laminage selon la revendication 1 ou 2, où la membrane de pressage (20) et/ou la feuille détachable (22, 22') sont réalisées comme bande sans fin traversant la chambre de compression (10).

4. Dispositif de laminage selon la revendication 3, où la membrane de pressage (20) et la feuille détachable (22, 22') peuvent être pré-contraintes séparément ou ensemble.

5. Dispositif de laminage selon l'une des revendications précédentes, où un dispositif de refroidissement et/ou un dispositif de pré-chauffage (14) sont disposés dans ou contre la paroi de chambre inférieure (12).

6. Dispositif de laminage selon l'une des revendications 1 à 5, où la feuille détachable (22') est prévue imperméable aux gaz et définit avec la membrane de pressage (20) une partie de chambre centrale qui peut être aérée et mise sous vide.

7. Dispositif de laminage selon l'une des revendications 1 à 5, où une membrane supérieure est disposée au-dessus de la feuille détachable (22), laquelle définit avec la membrane de pressage (20) une partie de chambre centrale qui peut être aérée et mise sous vide.

8. Dispositif de laminage selon l'une des revendications précédentes, où un cadre d'étanchéité (30, 30') entourant périphériquement la chambre est prévu entre la paroi supérieure et la paroi inférieure de chambre, au moins un élément espaceur (31, 31') s'étendant sensiblement parallèlement aux parois de chambre (11, 12) étant prévu à l'intérieur du cadre d'étanchéité, lequel divise partiellement ou complètement en sous-zones l'espace constitué du cadre d'étanchéité (30), de la feuille détachable (22, 22') et de la membrane de pressage (20).

9. Dispositif de laminage selon la revendication 8, où l'élément ou les éléments espaceurs (31) sont formés d'un seul tenant avec le cadre d'étanchéité.

10. Dispositif de laminage selon la revendication 8 ou 9, où l'élément ou les éléments espaceurs (31, 31') divise en sous-zones de grandeur égale l'espace constitué du cadre d'étanchéité (30, 30'), de la feuille détachable (22, 22') et de la membrane de pressage (20).

11. Dispositif de laminage selon la revendication 8, 9 ou 10, où au moins une ouverture d'aération (32) continue est prévue dans le cadre d'étanchéité (30, 30') et/ou dans l'élément ou les éléments espaceurs (31, 31'), par laquelle les sous-zones comprises entre la feuille détachable (22, 22') et la membrane de pressage (20) peuvent être aérées et mises sous vide en état de fermeture.

12. Procédé de laminage de piles (100) de composants, comprenant les étapes suivantes :
introduction d'au moins une pile de composants (100) dans une chambre de compression (10) avec une paroi de chambre supérieure et une paroi de chambre inférieure (11, 12), où sont disposées une membrane de pressage (20) et une feuille détachable (22, 22') au-dessus de celle-ci, lesquelles reçoivent entre elles la ou les piles de composants (100) pouvant être soulevées de la paroi de chambre inférieure (12),
fermeture étanche à la pression de la chambre de compression (100),
mise sous vide de la partie de chambre de compression située au-dessus et/ou en dessous de la membrane de pressage (20),
aération de la partie de chambre de compression située en dessous de la membrane de pressage (20), ou application de pression sur celles-ci,
la ou les piles de composants (100) de la paroi de chambre inférieure (12) étant ainsi soulevées, serrées contre la paroi de chambre supérieure (11) et comprimées par action de la chaleur depuis le haut.

13. Procédé selon la revendication 12, où la membrane de pressage (20) et/ou la feuille détachable (22, 22') sont réalisées chacune comme bande sans fin et traversent la chambre de compression (10), et où la membrane de pressage (20) est prévue pour convoyer la pile de composants (100) vers la chambre de compression (10).

14. Procédé selon la revendication 12 ou 13, où après introduction dans la chambre de compression (10), la ou les piles de composants (100) sont d'abord portées à une température de pré-chauffage, puis portées à une température de réticulation lors de l'étape de serrage contre la paroi de chambre supérieure (11), la température de réticulation étant supérieure à la température de pré-chauffage.

15. Procédé selon l'une des revendications 12 à 14, où l'étape d'aération ou d'application de pression comprend une première étape partielle où la membrane de pressage (20) soulève la ou les piles de composants (100) vers une position espacée de la paroi de chambre supérieure et de la paroi de chambre inférieure (11, 12) et l'y maintient, et une deuxième étape partielle consécutive où la ou les piles de composants (100) sont serrées contre la paroi de chambre supérieure (11) et comprimées par action de la chaleur depuis le haut.

16. Procédé selon l'une des revendications 12 à 15, où la feuille détachable (22') est prévue imperméable aux gaz, ou bien où une membrane supérieure est prévue au-dessus de la feuille détachable (22) pour définir avec la membrane de pressage (20) une partie de chambre centrale qui peut être aérée et mise sous vide, et, où, après l'étape de serrage, la ou les piles de composants (100) sont comprimées par aération de la partie de chambre supérieure et/ou de la partie de chambre centrale, ou application de pression sur celles-ci, et mise sous vide de la partie de chambre inférieure au moyen de la feuille détachable (22') imperméable aux gaz, ou de la membrane supérieure contre la paroi de chambre de compression inférieure (12) comprenant un dispositif de refroidissement et/ou un dispositif de pré-chauffage (14), en étant ainsi refroidies.
